# EUROPÄISCHE PATENTSCHRIFT

(11) **EP 2 137 545 B1**
(45) Veröffentlichungstag und Bekanntmachung des Hinweises auf die Patenterteilung: **10.05.2017**
(21) Anmeldenummer: 08716687.2
(22) Anmeldetag: 25.03.2008
(51) Int. Cl.: H04L 7/00, G01R 35/00, G01R 31/02

(54) **VERFAHREN ZUR ERMITTLUNG VON ZEITUNTERSCHIEDEN ZWISCHEN DURCH ZUMINDEST ZWEI GEKOPPELTE MESSGERÄTE GEMESSENEN SIGNALEN SOWIE MESSSYSTEM UND ENTSPRECHENDE UMSCHALTVORRICHTUNG**
METHOD FOR DETERMINING TIME DIFFERENCES BETWEEN SIGNALS MEASURED BY AT LEAST TWO COUPLED MEASURING DEVICES AND MEASUREMENT SYSTEM AND CORRESPONDING SWITCHING DEVICE
PROCÉDÉ DE DÉTERMINATION DE DIFFÉRENCES TEMPORELLES ENTRE DES SIGNAUX MESURÉS PAR AU MOINS DEUX APPAREILS DE MESURE COUPLÉS AINSI QUE SYSTÈME DE MESURE ET DISPOSITIF DE COMMUTATION CORRESPONDANT

(30) Priorität: 17.04.2007 DE 102007018096
(43) Veröffentlichungstag der Anmeldung: 30.12.2009
(73) Patentinhaber: Rohde & Schwarz GmbH & Co. KG, 81671 München (DE)
(72) Erfinder: STEFFENS, Johannes, 83026 Rosenheim (DE); FREIDHOF, Markus, 85614 Kirchseeon (DE); SCHMIDT, Kurt, 85567 Grafing (DE); MÜLLER, Manfred, 84453 Mühldorf (DE)
(74) Vertreter: Beder, Jens
(86) Internationale Anmeldenummer: PCT/EP2008/002348
(87) Internationale Veröffentlichungsnummer: WO 2008/125184

(56) Entgegenhaltungen:
- EP-A- 0 566 823
- WO-A-00/46612
- DE-A1- 3 808 304
- DE-A1- 10 131 712
- DE-A1- 10 331 092
- DE-A1-102004 034 879
- US-A1- 2006 055 394

## Beschreibung

Die Erfindung betrifft ein Verfahren zur Ermittelung von Zeitunterschieden zwischen durch zumindest zwei gekoppelte Messgeräte gemessenen Signalen sowie ein entsprechendes Messsystem zur Durchführung des Verfahrens und eine Umschaltvorrichtung.

Aus der DE 103 31 092 A1 ist es bekannt, zwei Messgeräte miteinander zu koppeln. Diese beiden Messgeräte werden mit ihrem jeweils einen Messsignaleingang mit einem Prüfling verbunden, um durch diesen Prüfling erzeugte Signale zu analysieren. Um zwei solche Messgeräte gemeinsam in einem Messsystem betreiben zu können, ist es erforderlich, die beiden Messgeräte zu synchronisieren. In der DE 103 31 092 ist es hierzu vorgeschlagen, in den Messgeräten jeweils einen über eine Phasenregelschleife phasengeregelten Frequenzgenerator vorzusehen und die Ausgänge und Phasensynchronisiereingänge der beiden Messgeräte miteinander zu verbinden. Damit wird eine absolute Phasensynchronisation zwischen den beiden zu einem Messsystem gekoppelten Messgeräten erreicht.

Nachteilig in der DE 103 31 092 A1 beschriebenen Messsystem ist es, dass zwar eine exakte Phasenlage der beiden Messgeräte zueinander sichergestellt wird, beispielsweise aber unterschiedliche Laufzeiten der Messsignale auf dem Signalweg bis zur abschließenden Analyse unberücksichtigt bleiben. Damit wird ein Zeitversatz, der zwischen den an dem jeweiligen Messgerät ankommenden Messsignal relativ zu einem an dem anderen Messgerät ankommenden Messsignal auftritt, nicht erkannt.

WO00/46612( Advantest) offenbart einen Vektornetzwerkanalysator mit einer Umschaltvorrichtung. Der Erfindung liegt daher die Aufgabe zugrunde, ein Verfahren sowie ein Messsystem und eine entsprechende Umschaltvorrichtung zu schaffen, mit dem ein Zeitversatz der in den Messgeräten ankommenden Messsignalen ermittelt werden kann.

Die Aufgabe wird durch das erfindungsgemäße Verfahren mit den Merkmalen des Anspruchs 1, die Umschaltvorrichtung mit den Merkmalen des Anspruchs 8 sowie das Messsystem mit den Merkmalen des Anspruchs 14 gelöst.

Bei dem erfindungsgemäßen Verfahren werden Zeitunterschiede zwischen durch zwei gekoppelte Messgeräte gemessenen Signalen ermittelt. Hierzu wird zunächst ein Zeitbasissignal für die Messgeräte generiert, um so die gekoppelten Messgeräte auf eine gemeinsame Zeitbasis zu synchronisieren. Durch einen Signalgenerator wird ferner ein gemeinsames Referenzsignal erzeugt. Das gemeinsame Referenzsignal wird den Messsignaleingängen der gekoppelten Messgeräte zugeführt und danach wird jeweils ein Messsignal zu diesen Messsignaleingängen der gekoppelten Messgeräte zugeführt. Da den Messsignaleingängen jeweils zunächst ein gemeinsames Referenzsignal zugeführt wird, kann die relative Lage des individuell erfassten Messsignals, das bei der eigentlichen Messung anschließend dem Messsignaleingang zugeführt wird, zu dem Referenzsignal die exakte zeitliche Lage der beiden Messsignale relativ zueinander ermittelt werden. Entscheidend dabei ist, dass das gemeinsame Referenzsignal die zeitliche Referenz für die Messsignale bildet, wobei dieses Referenzsignal bei der Durchführung einer Messung zunächst über den jeweiligen Messsignaleingang der gekoppelten Messgeräte zugeführt wird. Damit werden die durch eine Synchronisation der gekoppelten Messgeräte nicht erfassten bzw. nicht zu verhindernden Zeitunterschiede zwischen den Messsignalen, die beispielsweise durch Kabellängen oder interne Laufzeiten in den Messgeräten entstehen, ermittelt. Diese können anschließend rechnerisch berücksichtigt werden.

Erfindungsgemäß weist hierzu eine Umschaltvorrichtung einen ersten Messgeräteanschluss und zumindest einen zweiten Messgeräteanschluss sowie ein Referenzsignaleingang auf. Der erste Messgeräteanschluss ist wechselweise mit dem Referenzsignaleingang oder einem ersten Messanschluss und der zweite Messgeräteanschluss ist wechselweise mit dem Referenzsignaleingang oder jeweils einem Messanschluss verbindbar. Auf diese Weise kann entsprechend dem erfindungsgemäßen Messsystem jedes der Messgeräte mit seinem Messsignaleingang mit dem entsprechenden Messgeräteanschluss der Umschaltvorrichtung verbunden werden. Durch die Umschaltvorrichtung ist dann dem jeweiligen Messgeräteanschluss und somit dem Messsignaleingang der Messgeräte entweder das gemeinsame Referenzsignal oder aber ein jeweils zugeordnetes Messsignal zuführbar.

Die Unteransprüche betreffen vorteilhafte Weiterbildungen des erfindungsgemäßen Verfahrens sowie der erfindungsgemäßen Umschaltvorrichtung.

Der Wechsel zwischen dem Zuführen des gemeinsamen Referenzsignals und den jeweiligen Messsignalen wird vorzugsweise durch ein Triggersignal gesteuert, welches durch eines der Messgeräte erzeugt wird. Dies hat den Vorteil, dass durch eines der Messgeräte der zeitliche Ablauf beim Durchführen einer Messung gesteuert wird und infolgedessen für sämtliche gekoppelten Messgeräte gemeinsam und insbesondere zeitgleich der Wechsel zwischen dem zugeführten Referenzsignal und dem zugeführten jeweiligen Messsignal erfolgt.

Vorzugsweise wird zur Steuerung des Wechsels ein ansteuerbarer Ausgangsanschluss eines Messgeräts angesteuert. Eine solche Ansteuerung des Ausgangsanschlusses des Messgeräts kann dabei auch durch die jeweils verwendete und auf dem Messgerät ausgeführte Software erfolgen. Die Verwendung eines solchen ansteuerbaren Ausgangsanschlusses bietet somit die Möglichkeit auch bei solchen Messgeräten ein Triggersignal zu erzeugen, die über keinen dafür vorgesehenen, hardwareseitig implementierten Triggerausgang verfügen. Der ansteuerbare Ausgangsanschluss kann beispielsweise auch ein Druckeranschluss, ein serieller Anschluss oder ein USB Anschluss sein.

Das Triggersignal wird dabei vorzugsweise jeweils einem Triggereingang eines jeden der gekoppelten Messgeräte sowie der Umschaltvorrichtung zugeführt. Somit wird nicht nur der Umschaltvorgang also der Wechsel zwischen dem gemeinsamen Referenzsignal und dem jeweiligen Messsignal in der Umschaltvorrichtung durch das Triggersignal zeitlich gesteuert, sondern es wird auch der zeitliche Ablauf der eigentlichen Messung durch Zuführen des Triggersignals zu den gekoppelten Messgeräten gesteuert.

Damit wird durch das Triggersignal z. B. auch die Aufnahme der Abtastwerte durch das Messgerät zeitlich ausgelöst. Eine besonders einfache Durchführung des Verfahrens ist möglich, wenn das Triggersignal durch eine Steuerungssoftware in dem Messgerät erzeugt wird. Dies ermöglicht es insbesondere, den Zeitablauf durch einen Benutzer einfach beeinflussen zu können. So ist es bei einer bevorzugten Ausführungsform vorgesehen, während der Durchführung einer Messung periodisch zwischen dem Referenzsignal und den jeweiligen Messsignalen zu wechseln. Dabei kann die Zeitspanne, die zum Aufnehmen des eigentlichen Messsignals vorgesehen ist, individuell eingestellt werden.

Zur Ermittlung weiterer auftretender Laufzeitunterschiede, die beispielsweise durch die zum Anschluss des zu prüfenden Geräts an das Messsystem verwendeten Kabel auftreten, ist es weiterhin bevorzugt, das Referenzsignal zumindest einem zusätzlichen Referenzsignalausgang zuzuführen. Auf diese Weise kann der Einspeisepunkt des durch das zu prüfende Gerät erzeugten Signals in den zu dem Messgerät führenden Signalweg mit diesem zusätzlichen Referenzsignalausgang verbunden werden. Damit kann eine Kalibrierung auch unter Berücksichtigung der z. B. durch den Kunden verwendeten Kabel zum Verbinden des Messsystems mit dem zu prüfenden Gerät erfolgen.

In der erfindungsgemäßen Umschaltvorrichtung ist vorzugsweise ein erstes Schaltelement und zumindest ein zweites Schaltelement vorgesehen. Durch das erste Schaltelement wird der erste Messgeräteanschluss wechselweise mit dem ersten Messanschluss oder dem gemeinsamen Referenzsignaleingang verbunden. Entsprechend wird durch zumindest eine zweite Schaltelement jeweils ein zweiter Messgeräteanschluss wechselweise jeweils mit einem zweiten Messanschluss oder dem gemeinsamen Referenzsignaleingang verbunden. Die Umschaltvorrichtung wird damit so aufgebaut, dass für jedes der gekoppelten Messgeräte jeweils ein Messgeräteanschluss vorgesehen ist. Jedem dieser Messgeräteanschlüsse ist dabei ein Schaltelement zugeordnet, durch welches der Messgeräteanschluss entweder mit dem Referenzsignal oder mit dem jeweils zugeordneten Messanschluss verbindbar ist. Das Vorsehen jeweils genau eines Schaltelements in jedem der möglichen Signalwege hat den Vorteil, dass innerhalb der Umschaltvorrichtung in einfacher Weise gleiche Signalweglängen realisierbar sind.

Vorzugsweise ist ein drittes Schaltelement in einem gemeinsamen Abschnitt des Signalwegs des Referenzsignals vorgesehen. Das dritte Schaltelement ist zwischen dem Referenzsignaleingang und dem ersten bzw. den zweiten Schaltelementen angeordnet. Durch das Vorsehen eines dritten Schaltelements wird eine verbesserte Entkopplung des Referenzsignaleingangs von den Messanschlüssen erreicht.

An der Umschaltvorrichtung ist ferner zumindest ein Referenzsignalausgang vorgesehen, der mit dem Referenzsignaleingang verbunden ist. Durch diesen zusätzlichen Referenzsignalausgang ist es möglich, das Referenzsignal zur Kalibrierung der Messgeräte hinsichtlich Laufzeitunterschieden, die durch Kabel auftreten, mit denen das zu prüfende Gerät mit der Umschaltvorrichtung verbunden wird, zu verwenden.

An der Umschaltvorrichtung ist ferner vorzugsweise ein Triggersignaleingang vorgesehen. Die Schaltelemente sind dabei insbesondere so eingerichtet, dass sie mittels eines an dem Triggersignaleingang anliegenden Triggersignals betätigt werden können. Insbesondere ist es vorteilhaft, an der Umschaltvorrichtung einen ersten Triggersignalausgang und zumindest einen zweiten Triggersignalausgang vorzusehen, der mit dem Triggersignaleingang der Umschaltvorrichtung verbunden ist. Dabei ist der Aufbau der Umschaltvorrichtung vorzugsweise symmetrisch. Das bedeutet, dass ein an dem Triggersignaleingang anliegendes Triggersignal identische Laufzeiten zu dem ersten Triggersignalausgang und dem zumindest einen Triggersignalausgang aufweist. Bei Verwendung von mehreren zusätzlichen Referenzsignalausgängen, die mit dem Referenzsignaleingang verbunden sind, ist es ebenfalls bevorzugt, dass die Laufzeit zwischen dem Referenzsignaleingang und den jeweiligen Referenzsignalausgängen gleich ist.

Eine bevorzugte Ausführungsform des erfindungsgemäßen Verfahrens sowie der erfindungsgemäßen Umschaltvorrichtung und des Messsystems ist in der Zeichnung vereinfacht dargestellt und wird in der nachfolgenden Beschreibung näher erläutert. Es zeigen:
- Fig. 1: ein Blockschaltbild eines erfindungsgemäßen Messsystems mit einer erfindungsgemäßen Umschaltvorrichtung zur Durchführung des erfindungsgemäßen Verfahrens; und
- Fig. 2: ein Diagramm zum zeitlichen Ablauf bei der Durchführung des erfindungsgemäßen Verfahrens.

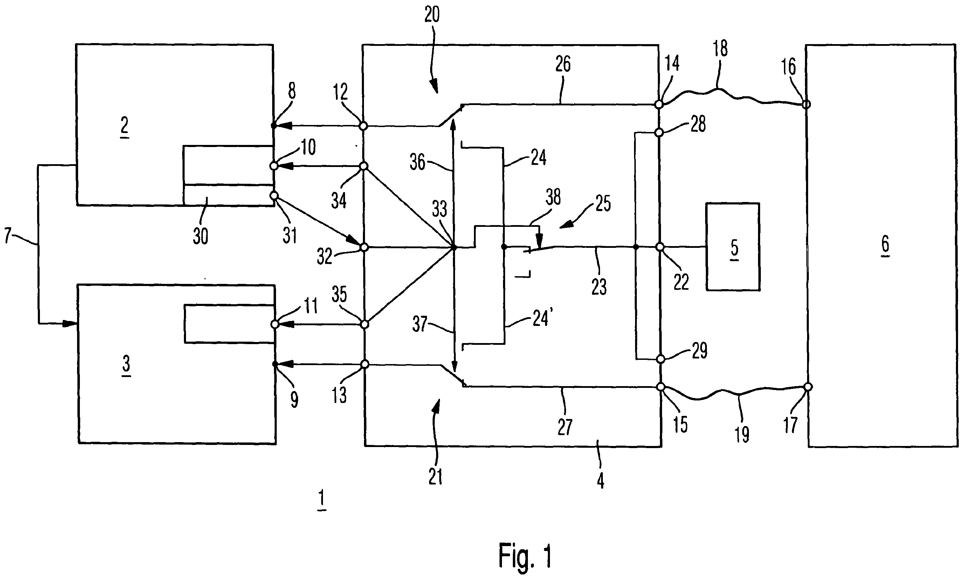

In der Fig. 1 ist ein Blockschaltbild eines erfindungsgemäßen Messsystems 1 zur Durchführung des erfindungsgemäßen Verfahrens dargestellt. Das Messsystem 1 umfasst ein erstes Messgerät 2, ein zweites Messgerät 3, eine Umschaltvorrichtung 4 sowie einen Signalgenerator 5. Das Messsystem 1 ist zum Messen von zwei durch ein zu testendes Gerät erzeugten Hochfrequenzsignalen vorgesehen. In dem dargestellten Ausführungsbeispiel ist das zu testende Gerät ein Mobilfunkgerät 6.

Das erste Messgerät 2 und das zweite Messgerät 3 sind miteinander gekoppelt. Die Kopplung erfolgt über ein gemeinsames Zeitbasissignal. Das gemeinsame Zeitbasissignal wird in dem dargestellten Ausführungsbeispiel von dem ersten Messgerät 2 erzeugt oder über das erste Messgerät 2 zur Verfügung gestellt und über eine Leitung 7 an das zweite Messgerät 3 übermittelt. Damit steht den beiden gekoppelten Messgeräten 2, 3 eine gemeinsame Zeitbasis zur Verfügung, auf die die beiden Messgeräte 2,3 aufsynchronisiert sind.

Das erste Messgerät 2 weist einen ersten Messsignaleingang 8 auf. Entsprechend weist das zweite Messgerät 3 einen zweiten Messsignaleingang 9 auf. Das dargestellte Ausführungsbeispiel ist auf die Kopplung von lediglich dem ersten Messgerät 2 sowie einem zweiten Messgerät 3 beschränkt. Es ist jedoch ebenso möglich, weitere Messgeräte in das Messsystem 1 zu integrieren. Die nachfolgenden, in Bezug auf das zweite Messgerät 3 bzw. die zugeordneten Anschlüsse der Umschaltvorrichtung 4 gemachten Ausführungen treffen dann in entsprechender Weise auf jedes weitere zweite Messgerät zu.

Neben dem jeweiligen Messsignaleingang 8 bzw. 9 des ersten Messgeräts 2 bzw. des zweiten Messgeräts 3 ist an jedem der Messgeräte 2, 3 ferner ein Triggersignaleingang 10 bzw. 11 ausgebildet. Über ein den Triggereingängen 10, 11 zugeführtes Triggersignal kann die Aufnahme des Messsignals bzw. die Annahmen von Signaldaten durch das erste Messgerät 2 und das zweite Messgerät 3 gesteuert und damit zeitlich aufeinander abgestimmt werden.

Zum Zuführen eines Messsignals oder eines Referenzsignals sind in nachfolgend noch zu beschreibender Weise ist mit dem Messsignaleingang 8 des ersten Messgeräts 2 ein erster Messgeräteanschluss 12 der Umschaltvorrichtung 4 verbunden. An der Umschaltvorrichtung 4 ist ferner ein zweiter Messgeräteanschluss 3 ausgebildet, der mit dem Messsignaleingang 9 des zweiten Messgeräts 3 verbunden ist. Zum Anschluss des zu prüfenden Mobilfunkgeräts 6 an das erfindungsgemäße Messsystem 1 ist an der Umschaltvorrichtung 4 ferner ein erster Messanschluss 14 und ein zweiter Messanschluss 15 ausgebildet. Der erste Messanschluss 14 wird mit einem ersten Prüfanschluss 16 des Mobilfunkgeräts 6 und der zweite Messanschluss 15 mit einem zweiten Prüfanschluss 17 des Mobilfunkgeräts 6 verbunden. Zur Verbindung der Messanschlüsse 14, 15 mit dem entsprechenden Prüfanschlüssen 16, 17 des Mobilfunkgeräts 6 wird ein erstes Kabel 18 und ein zweites Kabel 19 verwendet.

Zur Zuführung des über den ersten Prüfanschluss 16 bzw. den zweiten Prüfanschluss 17 des Mobilfunkgeräts 6 ausgegebenen Hochfrequenzsignals an das erste Messgerät 2 bzw. das zweite Messgerät 3 sind in der Umschaltvorrichtung 4 in nachfolgend detailliert beschriebener Weise der erste Messgeräteanschluss 12 mit dem ersten Messanschluss 14 und der zweite Messgeräteanschluss 13 mit dem zweiten Messanschluss 15 verbindbar.

Um über die Umschaltvorrichtung 4 nicht nur den Messgeräteanschluss 12 bzw. 13 mit dem jeweils zugeordneten Messanschluss 14 bzw. 15 verbinden zu können, ist in der Umschaltvorrichtung 4 ein erstes Schaltelement 20 sowie ein zweites Schaltelement 21 vorgesehen. In dem dargestellten Ausführungsbeispiel befinden sich die Schaltelemente 20, 21 in einer Position, in der die Messgeräteanschlüsse 12 bzw. 13 mit den zugeordneten Messanschlüssen 14 bzw. 15 verbunden sind. Werden die Schaltelemente 20 bzw. 21 betätigt, so werden sie in ihre jeweils zweite Schaltposition gebracht, in der den Messgeräten 2 und 3 ein gemeinsames Referenzsignal zugeführt wird.

Zum Erzeugen des gemeinsamen Referenzsignals ist ein Signalgenerator 5 vorgesehen. Der Signalgenerator 5 ist mit einem Referenzsignaleingang 22 der Umschaltvorrichtung 4 verbunden. Zur Zuführung des Referenzsignals zu den Messgeräten 2, 3 ist in der Umschaltvorrichtung 4 eine Referenzsignalleitung 23 vorgesehen. Die Referenzsignalleitung 23 teilt sich in einen ersten Signalzweig 24 und einen zweiten Signalzweig 25 auf. Der erste Signalzweig 24 führt das Referenzsignal zu dem ersten Schaltelement 20, während der zweite Signalzweig 25 des Referenzsignals zu dem zweiten Schaltelement 21 führt.

In der Referenzsignalleitung 23 ist ein drittes Schaltelement 25 angeordnet. Dieses zwischen dem ersten Schaltelement 20 bzw. dem zweiten Schaltelement 21 und dem Referenzsignaleingang 22 angeordnete und damit im gemeinsamen Abschnitt des Signalwegs des Referenzsignals liegende dritte Schaltelement 25 dient einer verbesserten Entkopplung des Referenzsignalseingangs 22 von dem ersten Schaltelement 20 und dem zweiten Schaltelement 21.

Während in dem dargestellten Ausführungsbeispiel das erste Schaltelement 20 und das zweite Schaltelement 21 den ersten Messgeräteanschluss 12 über eine erste Messsignalleitung 26 mit dem ersten Messanschluss 14 und den zweiten Messgeräteanschluss 13 über eine zweite Messsignalleitung 27 mit dem zweiten Messanschluss 15 verbindet, wird in der jeweils anderen Schaltposition des ersten Schaltelements 20 bzw. des zweiten Schaltelements 21 der erste Signalzweig 24 mit dem ersten Messgeräteanschluss 12 bzw. der zweite Signalzweig 25 mit dem zweiten Messgeräteanschluss 13 verbunden.

Wird also das erste Schaltelement 20 in seine zweite Schaltposition gebracht, so wird dem Messsignaleingang 8 des ersten Messgeräts 2 das von dem Signalgenerator 5 erzeugte Referenzsignal zugeführt. Gleichzeitig wird, wenn das zweite Schaltelement 21 sich in seiner zweiten Schaltposition befindet, dem Messsignaleingang 9 des zweiten Messgeräts 3 ebenfalls das Referenzsignal des Signalgenerators 5 zugeführt. Das dritte Schaltelement 25 befindet sich in der in der Fig. 1 dargestellten Position, in der der erste Signalzweig 24 und der zweite Signalzweig 25 über die Referenzsignalleitung 23 mit dem Referenzsignaleingang 22 verbunden sind.

Über zwei weitere Leitungszweige ist der Referenzsignaleingang 22 ferner zusätzlich mit einem ersten Referenzsignalausgang 28 und einem zweiten Referenzsignalausgang 29 verbunden. Damit ist an dem ersten Referenzsignalausgang 28 bzw. dem zweiten Referenzsignalausgang 29 ebenfalls das durch den Signalgenerator 5 erzeugte Referenzsignal abgreifbar. Die Leitungswege zwischen dem Referenzsignaleingang 22 und dem ersten Referenzsignalausgang 28 bzw. dem zweiten Referenzsignalausgang 29 sind dabei identisch, so dass ein Laufzeitunterschied zwischen dem an dem ersten Referenzsignalausgang 28 bzw. dem zweiten Referenzsignalausgang 29 anliegenden Referenzsignal nicht auftritt.

In entsprechender Weise sind die Laufzeiten des Referenzsignals von dem Referenzsignaleingang 22 bis hin zu dem ersten Schaltelement 20 über den ersten Signalzweig 24 bzw. zu dem zweiten Schaltelement 21 über den zweiten Signalzweig 25 konstant. Somit tritt auch bis zu dem ersten Schaltelement 20 bzw. zu dem zweiten Schaltelement 21 ein Zeitunterschied zwischen dem in dem Messsignaleingang 8 des ersten Messgeräts 2 bzw. dem Messsignaleingang 9 des zweiten Messgeräts 3 zugeführten Referenzsignal nicht auf. Sämtliche Zeitunterschiede, die zwischen einem abgetasteten Signal in dem ersten Messgerät 2 bzw. einem in dem zweiten Messgerät 3 abgetasteten Signal entstehen, haben daher ihre Ursache auf dem zwischen dem ersten Schaltelement 20 bzw. dem zweiten Schaltelement 21 und der Abtastung in dem ersten Messgerät 2 bzw. dem zweiten Messgerät 3 liegenden jeweiligen Signalweg.

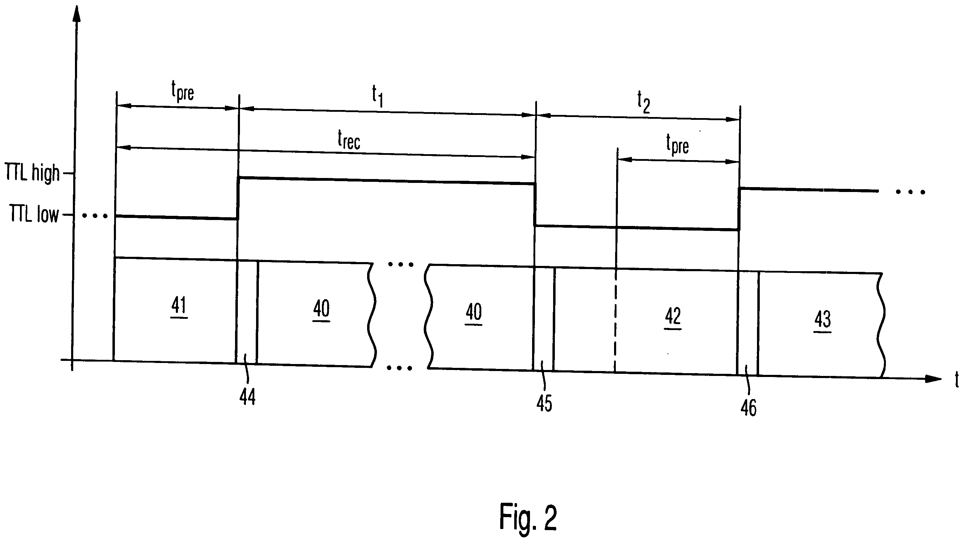

Zur zeitlichen Steuerung des Messablaufs wird ein Triggersignal verwendet. Das erste Messgerät 2 sowie das zweite Messgerät 3 in dem dargestellten Ausführungsbeispiel eines erfindungsgemäßen Messsystems 1 weisen dabei keinen hardwareseitig implementierten Triggerausgang auf. Es sind jedoch an dem ersten Messgerät 2 ein ansteuerbarer Ausgang 31 vorgesehen. Dieser ansteuerbare Ausgang 31 wird durch eine in dem ersten Messgerät 2 ausgeführte Steuerungssoftware angesteuert. Der ansteuerbare Ausgang 31 kann beispielsweise ein an dem ersten Messgerät 2 ausgeführter Anschluss einer Schnittstelle 30 sein. Eine solche Schnittstelle 30 kann z. B. eine serielle Schnittstelle, eine Druckerschnittstelle oder eine ähnliche ansteuerbare Schnittstelle sein. Der ansteuerbare Ausgang 31 ist mit einem Triggereingang 32 der Umschaltvorrichtung 4 verbunden. Der Triggereingang 32 ist mit einem Verzweigungspunkt 33 in der Umschaltvorrichtung 4 verbunden. Der Verzweigungspunkt 33 ist wiederum mit einem ersten Triggersignalausgang 34 und einem zweiten Triggersignalausgang 35 der Umschaltvorrichtung 4 verbunden. Ferner wirkt das über den Triggereingang 32 zugeführte Triggersignal sowohl auf das erste Schaltelement 20 als auch auf das zweite Schaltelement 21 sowie das dritte Schaltelement 25. In der Fig. 1 ist dies durch die Pfeile 36, 37 und 38 schematisch dargestellt. Der Triggereingang 32 ist beispielsweise als BNC-Buchse ausgeführt, über den ein TTL-Signal angelegt werden kann. Erfolgt dabei an dem Triggereingang 32 ein Pegelwechsel von "TTL high" auf "TTL low", so werden die Schaltelemente 20, 21 und 25 betätigt und in ihrer jeweils andere Schaltposition gebracht. Dies wird nachfolgend unter Bezugnahme auf die Fig. 2 noch ausführlich erläutert.

Die Leitungslängen für das Triggersignal innerhalb der Umschaltvorrichtung 4 ausgehend von dem Verbindungspunkt 33 und dem ersten Triggersignalausgang 34 bzw. dem zweiten Triggersignalausgang 35 sind vorzugsweise identisch, so dass ein Laufzeitunterschied des Triggersignals innerhalb der Umschaltvorrichtung 4 nicht auftritt.

Zur Durchführung des erfindungsgemäßen Verfahrens wird der Signalgenerator 5 auf eine Frequenz eingestellt, die etwa der Mittenfrequenz der an den Messgeräten 2 und 3 eingestellten Messfrequenz entspricht. Die Ansteuerung des Signalgenerators 5 erfolgt vorzugsweise über eine Steuerungssoftware, die beispielsweise auf dem ersten Messgerät 2 abgearbeitet wird. In dem dargestellten, bevorzugten Ausführungsbeispiel der Fig. 1 weist die Umschaltvorrichtung 4 keine eigene Stromversorgung auf. Die Stromversorgung der Umschaltvorrichtung 4 wird vorzugsweise über einen nicht dargestellten USB-Anschluss, der mit dem ersten Messgerät 2 verbunden ist, realisiert. Alternativ kann auch eine andere externe Stromversorgung mit der Umschaltvorrichtung 4 verbunden sein. Interne Stromversorgungen mit Transformatoren sollten dagegen vermieden werden.

Um eine qualitativ hochwertige Messung durchführen zu können, ist eine Entkopplung der Signalwege für das Referenzsignal und das eigentliche Messsignal erforderlich. Diese ist vorzugsweise größer als 60 dB, wobei eine besonders gute Entkopplung durch das dritte Schaltelement 25 erreicht wird, welches während der Zuführung eines Messsignals zu dem Messsignaleingang 8 des ersten Messgeräts 2 und des Messsignaleingangs 9 des zweiten Messgeräts 3 geöffnet ist. Der Messanschluss 14 und der Messanschluss 15 sind vorzugsweise mit mindestens 80 dB entkoppelt.

Der erste Messanschluss 14 und der zweite Messanschluss 15 sind zudem in nicht dargestellter Weise über einen Überspannungsschutz mit dem ersten Schaltelement 20 bzw. dem zweiten Schaltelement 21 verbunden.

Die Schaltelemente 20, 21 und 25 sind für eine maximale Schaltfrequenz von 10 Hz ausgelegt. Um einem Benutzer eine Überprüfung der korrekten Durchführung einer Messung zu ermöglichen, sind an der Umschaltvorrichtung 4 ferner Kontrolleinrichtungen vorgesehen, die z. B. die Schalterstellung der Schalterelemente 20, 21 und 25, das Vorliegen eines Referenzsignals und eines Triggersignals anzeigen. Solche Kontrolleinrichtungen können in besonders einfacher Weise als LEDs realisiert sein.

Bei der Durchführung des erfindungsgemäßen Verfahrens wird zunächst über die Verbindungsleitung 7 sichergestellt, dass das erste Messgerät 2 und das zweite Messgerät 3 auf einer identischen Zeitbasis arbeiten. Das hierfür erforderliche Zeitbasissignal wird in dem dargestellten bevorzugten Ausführungsbeispiel durch das erste Messgerät 2 erzeugt und über die Leitung 7 an das zweite Messgerät 3 übermittelt. Nach dem Start einer durchzuführenden Messung wird zunächst durch die auf dem ersten Messgerät 2 laufende Steuerungssoftware eine Triggersignal über den ansteuerbaren Ausgang 31 abgegeben und dieses dem Triggereingang 32 der Umschaltvorrichtung 4 zugeführt. Daraufhin werden die Schaltelemente 20, 21 und 25 so betätigt, dass über die Schaltelemente 25, sowie 20 und 21 das an dem Referenzsignaleingang 22 zugeführte Referenzsignal den Messgeräten 2 und 3 zugeführt wird. Nach Ablauf eines bestimmten Zeitintervalls, das unter Bezugnahme auf die Fig. 2 noch erläutert wird, wird nun beispielsweise das über den ansteuerbaren Ausgang 31 ausgebbare Signal gesetzt, so dass nun das erste Schaltelement 20, das zweite Schaltelement 21 sowie das dritte Schaltelement 25 in ihre jeweils andere Position gebracht werden. Damit ist nunmehr der erste Messgeräteanschluss 12 mit dem ersten Messanschluss 14 verbunden und der zweite Messgeräteanschluss 13 mit dem zweiten Messanschluss 15 verbunden. Gleichzeitig wird zur verbesserten Entkopplung das dritte Schaltelement 25 in seine geöffnete Position gebracht. In dieser Schaltposition wird dem ersten Messgerät 2 und dem zweiten Messgerät 3 jeweils ein Signal zugeführt, welches durch das Mobilfunkgerät 6 erzeugt und über den ersten Prüfanschluss 16 bzw. den zweiten Prüfanschluss 17 ausgegeben wird. Das in dem ersten Messgerät 2 bzw. in dem zweiten Messgerät 3 abgetastete erste Messsignal bzw. zweite Messsignal weisen dabei eine relative zeitliche Lage bezüglich des gemeinsamen Referenzsignals auf. Da das Referenzsignal ein gemeinsames Referenzsignal ist, welches bis zum Einspeisen in den Signalweg des ersten Messsignals bzw. den Signalweg des zweiten Messsignals an dem ersten Schaltelement 20 bzw. dem zweiten Schaltelement 21 keinen Laufzeitunterschied aufweist, ergibt sich aus der relativen zeitlichen Lage des ersten Messsignals relativ zu dem Referenzsignal in dem ersten Messgerät 2 bzw. der relativen zeitlichen Lage des zweiten Messsignals in dem zweiten Messgerät 3 der Zeitunterschied zwischen dem ersten Messsignal und dem zweiten Messsignal. Damit kann durch Auswerten dieses so ermittelten Zeitunterschieds eine zeitliche Korrelation zwischen dem ersten Messsignal und dem zweiten Messsignal erzeugt werden und bei einer Analyse der gemessenen Signale durch das erste bzw. zweite Messgerät 2, 3 berücksichtigt werden.

Vorzugsweise wird vor jeder Aufzeichnung eines ersten bzw. zweiten Messsignals, welches von dem Mobilfunkgerät 6 generiert und über den ersten Prüfanschluss 16 bzw. den zweiten Prüfanschluss 17 ausgegeben wird, über eine bestimmte Zeitdauer das gemeinsame und in seiner Frequenz abgestimmte Referenzsignal des Signalgenerators 5 dem ersten Messgerät 2 bzw. dem zweiten Messgerät 3 zugeführt.

Das periodische Umschalten zwischen den Pegeln "TTL high" und "TTL low" an dem ansteuerbaren Ausgang 31 wird durch die Steuerungssoftware bewirkt. Damit kann insbesondere festgelegt werden, über welche Zeitdauer das Referenzsignal den Messgeräten 2 und 3 zugeführt werden soll und welche Zeitdauer zur Aufnahme der beiden Messsignal an dem Messsignaleingang 8 des ersten Messgeräts 2 und dem Messsignaleingang 9 des zweiten Messsignals 3 zur Verfügung stehen soll. Diese Zeitintervalle sind durch einen Nutzer einstellbar und durch Realisierung des Triggersignals über einen ansteuerbaren Ausgang 31 durch die Steuerungssoftware in einfacher Weise umsetzbar.

Zusätzlich zu den unterschiedlichen Laufzeiten der Signale auf der zu den Messgeräten 2, 3 hin gerichteten Seite der Schaltelemente 20, 21 und dem sich daraus ergebenden Zeitunterschied zwischen dem ersten Messsignal und dem zweiten Messsignal, welche in dem ersten Messgerät 2 bzw. dem zweiten Messgerät 3 abgetastet werden, können weitere Laufzeitunterschiede auf der zum Mobilfunkgerät 6 hin orientierten Seite des ersten Schaltelements 20 bzw. des zweiten Schaltelements 21 auftreten. Diese können einerseits durch die erste Messsignalleitung 26 bzw. die zweite Messsignalleitung 27 und andererseits durch die verwendeten Kabel 18, 19 auftreten. Während bei entsprechender Fertigung der Umschaltvorrichtung 4 eine gleiche Laufzeit über die erste Messsignalleitung 26 bzw. die zweite Messsignalleitung 27 sichergestellt werden kann, ist eine Verwendung von unterschiedlichen Kabellängen durch die Kabel 18 und 19 nicht auszuschließen. Um bei der Kalibrierung der Messgeräte 2 und 3 auch diese Laufzeitunterschiede zu erfassen, wird das mit dem ersten Prüfanschluss 16 verbundene Ende des Kabels 18 mit dem ersten Referenzsignalausgang 28 verbunden. Gleichzeitig wird das zweite Kabel 19 mit dem an dem zweiten Prüfanschluss 17 angeschlossenen Ende mit dem zweiten Referenzsignalausgang 29 verbunden. Da, wie dies vorstehend bereits erläutert wurde, von dem ersten Referenzsignalausgang 28 und dem zweiten Referenzsignalausgang 29 das Referenzsignal ohne Laufzeitunterschiede in den zur Messung verwendeten Signalzweig über das erste Kabel 18 bzw. das zweite Kabel 19 eingespeist wird, lässt sich somit der bis zu den Schaltelementen 20, 21 auftretende Laufzeitunterschied relativ zu dem Referenzsignal in vorstehend bereits beschriebener Weise durch wechselweises Zuführen des Referenzsignals über den ersten Signalleitungszweig 24 bzw. dem zweiten Signalleitungszweig 24', die erste Messsignalleitung 26 bzw. die zweite Messsignalleitung 27 ermitteln.

Der Ablauf des erfindungsgemäßen Verfahrens wird unter Bezugnahme auf Fig. 2 nachfolgend noch detailliert erläutert. Zunächst liegt an dem ansteuerbaren Ausgang 31 ein niedriger Pegel eines TTL-Signals an. Das erste Schaltelement 20 verbindet daher den ersten Messgeräteanschluss 12 mit dem ersten Signalzweig 24. Das zweite Schaltelement 21 verbindet dagegen den zweiten Messgeräteanschluss 13 mit dem zweiten Signalzweig 24'.

Das dritte Schaltelement 25 ist in seine in der Fig. 1 dargestellten Position, so dass das Referenzsignal, welches durch den Signalgenerator 5 erzeugt wird, dem Messsignaleingang 8 des ersten Messgeräts 2 und dem Messsignal 9 des zweiten Messgeräts 3 zugeführt wird. Nach Ablauf einer ersten Zeitdauer tₚᵣₑ (pretrigger) wird das Triggersignal an dem ansteuerbaren Ausgang 31 auf "high" gesetzt. Infolgedessen werden das erste Schaltelement 20 und das zweite Schaltelement 21 betätigt und in ihre in der Fig. 1 dargestellte Position gebracht.

Gleichzeitig wird das dritte Schaltelement 25 geöffnet. An dem Messsignaleingang 8 bzw. dem Messsignaleingang 9 des ersten Messgeräts 2 bzw. des zweiten Messgeräts 3 liegt nun das erste bzw. das zweite Messsignal an. Nach Ablauf einer Zeitdauer t₁ wird das an dem ansteuerbaren Ausgang 31 anliegende Triggersignal wieder zurückgesetzt und infolgedessen die Schaltelemente 20, 21 und 25 erneut in ihre jeweils andere Position gebracht. Nun wird dem ersten Messgerät 2 und dem zweiten Messgerät 3 wieder das gemeinsame Referenzsignal zugeführt. Das Triggersignal an dem ansteuerbaren Ausgang 31 bleibt so lange auf "low", wie es durch eine einstellbare zweite Zeitdauer t₂ vorgeben ist. Die einstellbare Zeitdauer t₂ setzt sich dabei zusammen aus einer Mindestzeitdauer (pretrigger) tₚᵣₑ, der zum Betätigen der Schaltelemente 20, 21 und 22 erforderlichen Zeitdauer sowie einer geringfügigen zeitlichen Zugabe.

Nach Ablauf dieser zweiten Zeitdauer t₂ wird das Triggersignal wieder auf "high" gesetzt. Der vorbeschriebene Verfahrensablauf wiederholt sich periodisch.

In der Fig. 2 ist zunächst ein Block 41 dargestellt, der der Aufnahme des Referenzsignals durch das erste Messgerät 2 und das zweite Messgerät 3 entspricht. Nach dem Setzen des Triggersignals auf "high" folgt ein Zeitabschnitt 44, in dem die Schaltelemente 20, 21 und 25 in ihre jeweils andere Position gebracht werden. Die Zeitdauer zum Betätigen der Schaltelemente 20, 21 und 25 ist typischerweise etwa 10 µs. Nach dem Umschalten der Schaltelemente 20, 21 und 25 erfolgt die eigentliche Aufnahme des ersten und des zweiten Messsignals. Dies ist als Zeitblock 40 dargestellt, dessen Unterbrechung veranschaulichen soll, dass die dargestellten Verhältnisse in der Fig. 2 nicht maßstäblich den Zeitverhältnissen bei der Durchführung einer realen Messung entsprechen müssen. Die erste Zeitdauer t₁, in der das Triggersignal auf "high" gesetzt ist, wird also von der zum Umschalten der Schaltelemente 20, 21 und 25 plus einer vom Kunden einstellbaren Aufnahmezeit zusammengesetzt. Die gesamte Aufnahmedauer t_{rec} setzt sich dabei aus t₁ und der Pretrigger-Zeit tₚᵣₑ zusammen. Aus der Zeitdauer, die die Messgeräte 2 und 3 benötigen, um nach dem Abschluss einer solchen Aufnahmedauer t_{rec} wieder einsatzbereit zu sein, setzt sich der zusätzliche Zeitanteil in der zweiten Zeitdauer t₂ zusammen. Nachdem also in dem Zeitblock 45 erneut die Schaltelemente 20, 21 und 25 in die jeweils andere Schaltposition gebracht wurden, und diese zusätzliche Zeitdauer verstrichen ist, beginnt in dem Zeitblock 42 wieder die Pretrigger-Zeit tₚᵣₑ, in der das Referenzsignal durch das erste Messgerät 2 und das zweite Messgerät 3 aufgezeichnet wird. Es schließt sich wiederum ein Zeitblock 46 an, in dem die Schaltelemente 20, 21 und 25 erneut betätigt werden, bevor wieder die eigentlichen Messsignale in dem Zeitblock 43 aufgezeichnet werden. Der jeweilige Beginn der Aufzeichnungen wird ebenfalls über das Triggersignal zeitlich gesteuert, wozu der Triggersignaleingang 10 bzw. der Triggersignaleingang 11 des ersten Messgeräts 2 bzw. des zweiten Messgeräts 3 mit dem Triggersignalausgang 34 bzw. dem zweiten Triggersignalausgang 35 verbunden ist. Durch die gleiche Laufzeit des Triggersignals innerhalb der Umschaltvorrichtung 4 wird dabei sichergestellt, dass der Beginn einer Messung zeitgleich erfolgt.

Das beschriebene Verfahren sowie das beschriebene Messsystem und die Umschaltvorrichtung sind von Pᵢₙ max minimal = 20 dBm bis zu Pᵢₙ min 0 -60 dBm vorgesehen. Die einstellbaren Frequenzen des ersten Messgeräts 2 und des zweiten Messgeräts 3 und somit auch die hierzu korrespondierenden Frequenz des gemeinsamen Referenzsignals reicht dabei von etwa 40 mHz bis 8 GHz.

Eine eindeutige Zuordnung der relativen Lage des Messsignals zu dem Referenzsignal ist nur innerhalb eines Zeitfensters von einer Periode des Referenzsignals möglich. Um auch größere Zeitunterschiede zwischen dem ersten und dem zweiten Messsignal bei der Abtastung des Messsignals durch das erste Messgerät 2 und das zweite Messgerät 3 ermitteln zu können, kann der Signalgenerator 5 zunächst mit einer niedrigeren Frequenz betrieben werden. Diese eingestellte Frequenz des Referenzsignals kann dann beispielsweise sukzessive bis hin zu der Mittenfrequenz der eingestellten Frequenz des Messgeräts 2, 3 gesteigert werden. Damit ist auch ein Zeitversatz detektierbar, der größer als eine Periode der Mittenfrequenz der eingestellten Messfrequenz des ersten Messgeräts 2 und des zweiten Messgeräts 3 ist.

Die Erfindung ist nicht auf das dargestellte Ausführungsbeispiel beschränkt.

## Patentansprüche

1. Verfahren zur Ermittlung von Zeitunterschieden zwischen durch zumindest zwei gekoppelte Messgeräte (2, 3) gemessenen Signalen, mit folgenden Verfahrensschritten:
- Generieren eines Zeitbasissignals für die gekoppelten Messgeräte (2, 3), indem ein Messgerät eine gemeinsame Zeitbasis für zumindest ein an dieses Messgerät gekoppeltes Messgerät bereitstellt,
- Erzeugen eines gemeinsamen Referenzsignals durch einen Signalgenerator (5),
- Zeitgleiches Zuführen des gemeinsamen Referenzsignals zu Messsignaleingängen (8, 9) der gekoppelten Messgeräte (2, 3) und danach
- Zuführen jeweils eines Messsignals zu jeweils zugeordneten Messsignaleingängen (8, 9) der gekoppelten Messgeräte (2, 3) und
- Ermitteln der relativen zeitlichen Lage der Messsignale zu dem Referenzsignal in jedem der gekoppelten Messgeräte (2, 3).

2. Verfahren nach Anspruch 1,
**dadurch gekennzeichnet,**
**dass** ein zeitgleicher Wechsel zwischen dem Zuführen des gemeinsamen Referenzsignals und den Messsignalen durch eines der Messgeräte (2,3) durch ein von diesem Messgerät (2, 3) erzeugtes Triggersignal gesteuert wird.

3. Verfahren nach Anspruch 2,
**dadurch gekennzeichnet,**
**dass** zur Ansteuerung des Wechsels ein ansteuerbarer Ausgangsanschluss (31) des Messgeräts (2) angesteuert wird.

4. Verfahren nach Anspruch 2 oder 3,
**dadurch gekennzeichnet,**
**dass** das Triggersignal gleichzeitig jeweils einem Triggereingang (10, 11) eines jeden der gekoppelten Messgeräte (2, 3) und einer Umschaltvorrichtung (4) zum Wechsel zugeführt wird.

5. Verfahren nach einem Anspruch 4,
**dadurch gekennzeichnet,**
**dass** das Triggersignal durch eine Steuerungssoftware in dem Messgerät (2) erzeugt wird.

6. Verfahren nach einem der Ansprüche 1 bis 5,
**dadurch gekennzeichnet,**
**dass** während einer Messung periodisch zwischen dem Referenzsignal und den den Messgeräten (1,2) zugeordneten Messsignalen an den zugeordneten Messsignaleingängen (8, 9) gewechselt wird.

7. Verfahren nach einem der Ansprüche 1 bis 6,
**dadurch gekennzeichnet,**
**dass** zur Ermittlung bei der Verbindung eines zu prüfenden Geräts (6) mit dem Messsystem (1) auftretenden Laufzeitunterschiede das Referenzsignal zumindest einem zusätzlichen Referenzsignalausgang (28, 29) zugeführt wird.

8. Umschaltvorrichtung mit einem ersten Messgeräteanschluss (12) und zumindest einem zweiten Messgeräteanschluss (13) und einem Referenzsignaleingang (22), wobei der erste Messgeräteanschluss (12) wechselweise mit dem Referenzsignaleingang (22) oder einem ersten Messanschluss (14) und der zumindest eine zweite Messgeräteanschluss (13) wechselweise mit dem Referenzsignaleingang (22) oder jeweils einem zweiten Messanschluss (15) verbindbar ist,
**dadurch gekennzeichnet, dass** den Messsignaleingängen der Messgeräte entweder das Referenzsignal als gemeinsames Referenzsignal zuführbar ist oder den Messsignaleingängen das jeweils zugeordnete Messsignal zuführbar ist.

9. Umschaltvorrichtung nach Anspruch 8,
**dadurch gekennzeichnet,**
**dass** in der Umschaltvorrichtung (4) ein erstes Schaltelement (20) und zumindest ein zweites Schaltelement (21) vorgesehen ist, wobei durch das erste Schaltelement (20) der erste Messgeräteanschluss (12) wechselweise mit dem ersten Messanschluss (14) oder dem Referenzsignaleingang (22) verbindbar ist und durch zumindest ein zweites Schaltelement (21) jeweils ein zweiter Messgeräteanschluss (13) wechselweise mit jeweils einem zweiten Messanschluss (15) oder dem Referenzsignaleingang (22) verbindbar ist.

10. Umschaltvorrichtung nach Anspruch 9,
**dadurch gekennzeichnet,**
**dass** zwischen dem Referenzsignaleingang (22) und dem ersten und zweiten Schaltelementen (20, 21) ein drittes Schaltelement (25) zum Entkoppeln des Referenzsignaleingangs (22) vorgesehen ist.

11. Umschaltvorrichtung nach einem der Ansprüche 8 bis 10,
**dadurch gekennzeichnet,**
**dass** an der Umschaltvorrichtung (4) zumindest ein Referenzsignalausgang (28, 29) vorgesehen ist, der mit dem Referenzsignaleingang (22) verbunden ist.

12. Umschaltvorrichtung nach einem der Ansprüche 8 bis 11,
**dadurch gekennzeichnet,**
**dass** ein Triggersignaleingang (32) vorgesehen ist und die Schaltelemente (20, 21, 25) so eingerichtet sind, dass sie mittels eines an dem Triggersignaleingang (32) anliegenden Triggersignals gleichzeitig betätigt werden.

13. Umschaltvorrichtung nach einem der Ansprüche 8 bis 12,
**dadurch gekennzeichnet,**
**dass** der Triggersignaleingang (32) der Umschaltvorrichtung (4) mit einem ersten Triggersignalausgang (34) und zumindest einem zweiten Triggersignalausgang (35) verbunden ist.

14. Messsystem mit einem ersten Messgerät (2) und zumindest einem zweiten Messgerät (3) mit jeweils zumindest einem Messsignaleingang (8, 9), wobei das erste Messgerät (2) und das zumindest eine zweite Messgerät (3) eine durch das erste Messgerät (2) bereitgestellte gemeinsame Zeitbasis aufweisen,
**dadurch gekennzeichnet,**
**dass** der zumindest eine Messsignaleingang (8) des ersten Messgeräts (2) mit einem ersten Messgeräteanschluss (12) und die zweiten Messsignaleingänge (9) der zweiten Messgeräte (3) mit dem jeweils einem zweiten Messgeräteanschluss (13) einer Umschaltvorrichtung (4) nach einem der Ansprüche 8 bis 13 verbunden sind.

## Claims

1. Method for determining time differences between signals measured by at least two coupled measuring devices (2, 3), with the following method steps:
- generation of a time base signal for the coupled measuring devices (2, 3) by one measuring device providing a common time base for at least one measuring device coupled to this measuring device,
- production of a common reference signal by a signal generator (5),
- simultaneous feeding of the common reference signal to measurement signal inputs (8, 9) of the coupled measuring devices (2, 3) and thereafter
- feeding of in each case one measurement signal to in each case associated measurement signal inputs (8, 9) of the coupled measuring devices (2, 3) and
- determination of the relative position in time of the measurement signals relative to the reference signal in each of the coupled measuring devices (2, 3).

2. Method according to claim 1,
**characterised in that** a simultaneous change between the feeding of the common reference signal and the measurement signals by one of the measuring devices (2, 3) is controlled by a trigger signal produced by this measuring device (2, 3).

3. Method according to claim 2,
**characterised in that** to actuate the change an actuatable output connection (31) of the measuring device (2) is actuated.

4. Method according to claim 2 or 3,
**characterised in that** the trigger signal is simultaneously fed in each case to a trigger input (10, 11) of each of the coupled measuring devices (2, 3) and a switching device (4) for the change.

5. Method according to claim 4,
**characterised in that** the trigger signal is produced by a control software in the measuring device (2).

6. Method according to one of claims 1 to 5,
**characterised in that** during a measurement periodically a change is made between the reference signal and the measurement signals associated with the measuring devices (1, 2) at the associated measurement signal inputs (8, 9). (?)

7. Method according to one of claims 1 to 6,
**characterised in that** to determine transit time differences occurring when connecting a device (6) to be checked with the measuring system (1) the reference signal is fed to at least one additional reference signal output (28, 29).

8. Switching device with a first measuring device connection (12) and at least one second measuring device connection (13) and a reference signal input (22), wherein the first measuring device connection (12) can be connected alternately with the reference signal input (22) or a first measurement connection (14) and the at least one second measuring device connection (13) can be connected alternately with the reference signal input (22) or in each case a second measurement connection (15), **characterised in that** either the reference signal can be fed to the measurement signal inputs of the measuring devices as common reference signal or the associated measurement signal can be fed to the measurement signal inputs.

9. Switching device according to claim 8,
**characterised in that** a first switching element (20) and at least one second switching element (21) is provided in the switching device (4), wherein the first measuring device connection (12) can be connected alternately with the first measurement connection (14) or the reference signal input (22) by the first switching element (20) and in each case a second measuring device connection (13) can be connected alternately with in each case a second measurement connection (15) or the reference signal input (22) by at least one second switching element (21).

10. Switching device according to claim 9,
**characterised in that** a third switching element (25) is provided between the reference signal input (22) and the first and second switching elements (20, 21) to decouple the reference signal input (22).

11. Switching device according to one of claims 8 to 10,
**characterised in that** the switching device (4) is provided with at least one reference signal output (28, 29) which is connected with the reference signal input (22).

12. Switching device according to one of claims 8 to 11,
**characterised in that** a trigger signal input (32) is provided and the switching elements (20, 21, 25) are set up so that they are actuated simultaneously by means of a trigger signal present at the trigger signal input (32).

13. Switching device according to one of claims 8 to 12,
**characterised in that** the trigger signal input (32) of the switching device (4) is connected with a first trigger signal output (34) and at least one second trigger signal output (35).

14. Measuring system with a first measuring device (2) and at least one second measuring device (3) with in each case at least one measurement signal input (8, 9), wherein the first measuring device (2) and the at least one second measuring device (3) have a common time base provided by the first measuring device (2), **characterised in that** the at least one measurement signal input (8) of the first measuring device (2) is connected with a first measuring device connection (12) and the second measurement signal inputs (9) of the second measuring devices (3) are connected with the in each case one second measuring device connection (13) of a switching device (4) according to one of claims 8 to 13.

## Revendications

1. Procédé de détermination de différences temporelles entre des signaux mesurés par au moins deux appareils de mesure (2, 3) couplés, comprenant les étapes de procédé suivantes :
- la génération d'un signal de base temporel pour les appareils de mesure (2, 3) couplés, par le fait qu'un appareil de mesure fournit une base de temps commune pour au moins un appareil de mesure couplé à cet appareil de mesure,
- la production d'un signal de référence commun par un générateur de signal (5),
- l'amenée simultanée du signal de référence commun aux entrées de signal de mesure (8, 9) des appareils de mesure (2, 3) couplés puis
- l'amenée respectivement d'un signal de mesure aux entrées de signal de mesure (8, 9) respectivement associées des appareils de mesure (2, 3) couplés et
- la détermination de la position temporelle relative des signaux de mesure par rapport au signal de référence dans chacun des appareils de mesure (2, 3) couplés.

2. Procédé selon la revendication 1,
**caractérisé en ce que**
un changement simultané entre l'amenée du signal de référence commun et les signaux de mesure est commandé par un des appareils de mesure (2, 3) à la suite d'un signal de déclenchement produit par cet appareil de mesure (2, 3).

3. Procédé selon la revendication 2,
**caractérisé en ce que**
pour commander le changement, un raccord de sortie (31) pouvant être commandé de l'appareil de mesure (2) est commandé.

4. Procédé selon la revendication 2 ou 3,
**caractérisé en ce que**
le signal de déclenchement est amené simultanément respectivement à une entrée de déclenchement (10, 11) de chacun des appareils de mesure (2, 3) couplés et à un dispositif de commutation (4).

5. Procédé selon la revendication 4,
**caractérisé en ce que**
le signal de déclenchement est produit par un logiciel de commande dans l'appareil de mesure (2).

6. Procédé selon l'une quelconque des revendications 1 à 5,
**caractérisé en ce que**
pendant une mesure, un changement est effectué périodiquement entre le signal de référence et les signaux de mesure associés aux appareils de mesure (1, 2) au niveau des entrées de signal de mesure (8, 9) associées.

7. Procédé selon l'une quelconque des revendications 1 à 6,
**caractérisé en ce que**
pour déterminer les différences de temps de propagation apparaissant lors de la liaison d'un appareil (6) à contrôler au système de mesure (1), le signal de référence est amené au moins à une sortie de signal de référence (28, 29) supplémentaire.

8. Dispositif de commutation comprenant un premier raccord d'appareil de mesure (12) et au moins un deuxième raccord d'appareil de mesure (13) et une entrée de signal de référence (22), le premier raccord d'appareil de mesure (12) pouvant être relié sélectivement à l'entrée de signal de référence (22) ou à un premier raccord de mesure (14) et le ou les deuxièmes raccords d'appareil de mesure (13) pouvant être reliés sélectivement à l'entrée de signal de référence (22) ou respectivement à un deuxième raccord de mesure (15),
**caractérisé en ce que**
le signal de référence en tant que signal de référence commun peut être amené aux entrées de signal de mesure des appareils de mesure ou le signal de mesure respectivement associé peut être amené aux entrées de signal de mesure.

9. Dispositif de commutation selon la revendication 8,
**caractérisé en ce que**
un premier élément de commutation (20) et au moins un deuxième élément de commutation (21) sont prévus dans le dispositif de commutation (4), le premier élément de commutation (20) permettant de relier le premier raccord d'appareil de mesure (12) sélectivement au premier raccord de mesure (14) ou à l'entrée de signal de référence (22) et au moins un deuxième élément de commutation (21) permettant de relier respectivement un deuxième raccord d'appareil de mesure (13) sélectivement à respectivement un deuxième raccord de mesure (15) ou à l'entrée de signal de référence (22).

10. Dispositif de commutation selon la revendication 9,
**caractérisé en ce que**
un troisième élément de commutation (25) destiné à découpler l'entrée de signal de référence (22) est prévu entre l'entrée de signal de référence (22) et les premier et deuxième éléments de commutation (20, 21).

11. Dispositif de commutation selon l'une quelconque des revendications 8 à 10,
**caractérisé en ce que**
au moins une sortie de signal de référence (28, 29), qui est reliée à l'entrée de signal de référence (22), est prévue sur le dispositif de commutation (4).

12. Dispositif de commutation selon l'une quelconque des revendications 8 à 11,
**caractérisé en ce que**
une entrée de déclenchement (32) est prévue et les éléments de commutation (20, 21, 25) sont conçus de sorte qu'ils sont actionnés simultanément au moyen d'un signal de déclenchement appliqué sur l'entrée de signal de déclenchement (32).

13. Dispositif de commutation selon l'une quelconque des revendications 8 à 12,
**caractérisé en ce que**
l'entrée de signal de déclenchement (32) du dispositif de commutation (4) est reliée à une première sortie de signal de déclenchement (34) et au moins à une deuxième sortie de signal de déclenchement (35).

14. Système de mesure comprenant un premier appareil de mesure (2) et au moins un deuxième appareil de mesure (3) comprenant chacun au moins une entrée de signal de mesure (8, 9), le premier appareil de mesure (2) et le ou les deuxièmes appareils de mesure (3) comprenant une base temporelle commune fournie par le premier appareil de mesure (2),
**caractérisé en ce que**
l'entrée ou les entrées de signal de mesure (8) du premier appareil de mesure (2) sont reliées à un premier raccord d'appareil de mesure (12) et les deuxièmes entrées de signal de mesure (9) des deuxièmes appareils de mesure (3) sont reliées au ou aux deuxièmes raccords d'appareil de mesure (13) d'un dispositif de commutation (4) selon l'une quelconque des revendications 8 à 13.
